(19) Europäisches Patentamt
European Patent Office
Office européen des brevets

(11) **EP 1 766 665 B1**

(12) **EUROPEAN PATENT SPECIFICATION**

(45) Date of publication and mention
of the grant of the patent:
**23.05.2018 Bulletin 2018/21**

(51) Int Cl.:
**B01D 7/00** (2006.01)     **C23F 1/00** (2006.01)
**C23F 1/12** (2006.01)     **H01J 37/32** (2006.01)
**H01L 21/67** (2006.01)

(21) Application number: **05756952.7**

(22) Date of filing: **17.06.2005**

(86) International application number:
**PCT/GB2005/002386**

(87) International publication number:
**WO 2005/124827 (29.12.2005 Gazette 2005/52)**

(54) **IMPROVED METHOD FOR THE ETCHING OF MICROSTRUCTURES**

VERBESSERTES VERFAHREN ZUM ÄTZEN VON MIKROSTRUKTUREN

PROCÉDÉ AMÉLIORÉ DESTINÉ À LA GRAVURE DE MICROSTRUCTURES

(84) Designated Contracting States:
**AT BE BG CH CY CZ DE DK EE ES FI FR GB GR HU IE IS IT LI LT LU MC NL PL PT RO SE SI SK TR**

(30) Priority: **17.06.2004 GB 0413554**

(43) Date of publication of application:
**28.03.2007 Bulletin 2007/13**

(73) Proprietor: **Memsstar Limited
Kirkton Campus
Livingston
West Lothian EH54 7BN (GB)**

(72) Inventors:
• **O'HARA, Anthony**
**c/o Point 35 Microstructures Ltd.,
Livingston EH54 8SF (GB)**
• **LEAVY, Michael**
**c/o Point 35 Microstructures Ltd.,
Livingston EH54 8SF (GB)**
• **PRINGLE, Graeme**
**c/o Point 35 Microstructures Ltd.,
Livingston EH54 8SF (GB)**
• **McKIE, Anthony**
**c/o Point 35 Microstructures Ltd.,
Livingston EH54 8SF (GB)**

(74) Representative: **Fulton, David James et al
Lincoln IP
9 Victoria Street
Aberdeen AB10 1XB (GB)**

(56) References cited:
EP-A- 0 688 045          EP-A- 1 531 145
EP-A2- 0 878 824        WO-A-98/32163
WO-A1-03/036706       JP-A- S61 181 131
US-A1- 2002 033 229    US-A1- 2002 195 423
US-A1- 2004 025 370    US-A1- 2004 069 318
US-B1- 6 736 987

• **PATENT ABSTRACTS OF JAPAN vol. 1998, no. 13, 30 November 1998 (1998-11-30) -& JP 10 209088 A (MITSUBISHI ELECTRIC CORP), 7 August 1998 (1998-08-07)**
• **CHANG F I ET AL: "GAS-PHASE SILICON MICROMACHINING WITH XENON DIFLUORIDE" PROCEEDINGS OF THE SPIE, SPIE, BELLINGHAM, VA, US, vol. 2641, 24 October 1995 (1995-10-24), pages 117-128, XP001145944 ISSN: 0277-786X cited in the application**

EP 1 766 665 B1

**Description**

This invention relates to the field of the manufacturing of microstructures. The microstructures are in the form of micro electromechanical systems (MEMS) that require the removal of a material relative to a substrate or other deposited material. More particularly, this invention relates to an improved method for the gas phase etching process involved in the manufacture of these microstructures.

MEMS is a term generally employed by those skilled in the art to describe devices which are fabricated onto a substrate using micro-engineering or lithography based processes. These devices can include mechanical sensors and machines, optical components, bio-engineered devices, RF devices as well as many others.

The employment of an etching process to remove sacrificial layers or regions in a multilayer structure without the removal of an adjacent layer or region is a necessary and common process in the manufacture of MEMS. It is well known to those skilled in the art to employ xenon difluoride ($XeF_2$) etching techniques within this procedure since $XeF_2$ isotropically etches silicon spontaneously in the vapour phase without the requirement for external energy sources or ion bombardment. Furthermore, at room temperature the etching rate is high and the selectivity with other materials commonly used in MEMS manufacture (e.g. many metals, dielectrics and polymers) is also known to be extremely high. The above factors make this etching process ideal for the release of MEMS structures when using silicon as the sacrificial material.

At room temperature and atmospheric pressure $XeF_2$ is a white crystalline solid, the crystal size being determined by the conditions in which solidification takes place. Sublimation takes place at a partial vapour pressure of ~533 Pa (~4 Torr) at 25 °C. Partial vapour pressure refers to the pressure exerted by a particular component of a mixture of gas, in this case $XeF_2$.

However, one drawback to the use of $XeF_2$ is that it forms HF in the presence of water vapour and so poses a significant safety hazard to users if it is not carefully isolated.

$XeF_2$ gas etches silicon with the primary reaction as defined by the following expression:

$$2XeF_2 + Si - 2Xe + SiF_4 \qquad (1)$$

This reaction is exothermic, and so substrate temperature increases are observed during the etching process. As can be seen, the rate at which the etching of silicon takes place is proportional to the amount of $XeF_2$ vapour present i.e. the higher the $XeF_2$ partial pressure the higher the etch rate.

One of the first references to this type of etching with respect to MEMS is in E. Hoffman, B. Warneke, E. Kruglick J. Weigold and K.S.J. Pister, "3D structures with piezoresistive sensors in standard CMOS", Proceedings of IEEE Micro Electro Mechanical Systems Workshop (MEMS '95), p.288-293, 1995. Within this apparatus a continuous flow of $XeF_2$ gas was employed for the etching process.

Following further refinement of this continuous flow process, the apparatus employed was described in detail within F.I. Chang, R. Yeh, G. Lin, P.B. Chu, E. Hoffman, E.J.J. Kruglick, K.S.J. Pister, and M.H. Hecht Gas-Phase Silicon Micromachining With Xenon Difluoride", in Microelectronic Structures And Microelectromechanical Devices For Optical Processing And Multimedia Applications, Proc. SPIE. Vol. 2641, p. 117-128, 1995 and US Patent No. 5,726,480 in the name of The Regents of the University of California, see Figure 7.

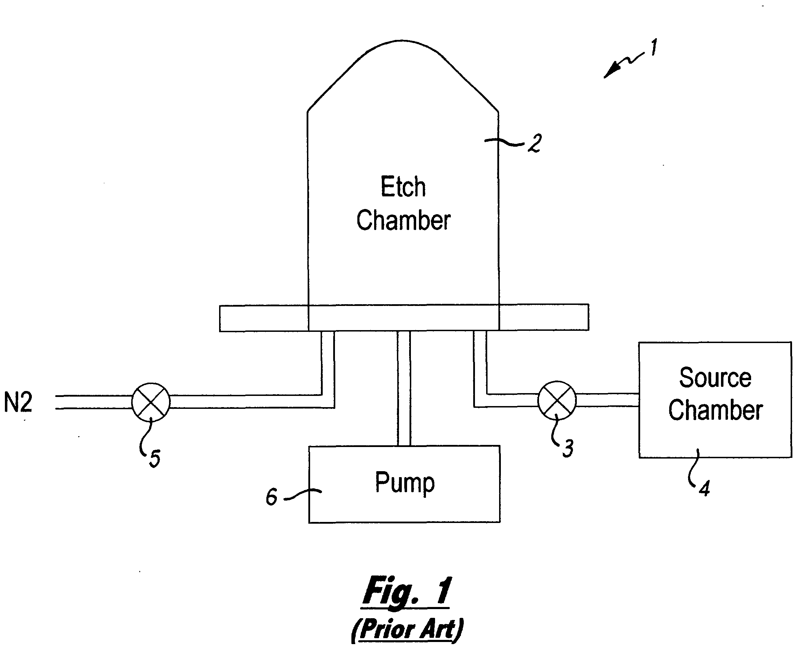

The continuous etching apparatus 1 of Figure 1 can be seen to comprise an etching chamber 2 connected by a first valve 3 to a source chamber 4 that contains the $XeF_2$ crystals. Nitrogen ($N_2$) purging is also provided to the etching chamber 2 through a second valve 5. Once the etching chamber 2, with the sample devices inside, has been pumped down to a moderate vacuum by a vacuum pump 6, the first valve 3 is opened and small amounts of the $XeF_2$ crystals vaporise in the low pressure and so $XeF_2$ gas enters the etching chamber 2. Under these conditions, typical etch rates of 1 - 3 micrometers (microns) per minute are observed, although as is appreciated by those skilled in the art, the exact etching rate is dependent on the size and density of the features being etched.

A major disadvantage with this continuous etching apparatus 1 is the lack of control it provides for the etching process. The first valve 3 moves between an open and closed position so the flow of the etching gas is correspondingly either on or off. A further disadvantage of this system resides in the fact that it depends directly on a pressure differential between the source chamber 4 and the etching chamber 2 so as to cause the required vaporisation of the $XeF_2$ crystals. Therefore, any increase in pressure within the etching chamber 2 or decrease in pressure within the source chamber 4 results in a reduced efficiency in the operation of the apparatus. The etching process is therefore directly dependent on the quantity, age and history of $XeF_2$ crystals within the source chamber 4.

It is also recognised by those skilled in the art that since the reaction of equation (1) is exothermic, cooling of the sample is desirable to prevent the temperature of the sample to increase causing an issue such as thermal shock which can damage the sample; this is commonly achieved by adding an inert gas. Typically, this can be achieved by opening the second valve 5 so as to allow nitrogen gas into the etching chamber 2 since this inert gas acts as coolant. However, it should be noted that when the nitrogen gas is introduced into the etching chamber 2 the efficiency of the etching process is decreased. This occurs because of the resulting increase in the pressure within the etching chamber that then causes a reduction in the flow of $XeF_2$ into the etching chamber 2.

Historically, continuous etching systems have been regarded as wasteful and expensive since the constant flow of $XeF_2$ gas increased the quantity of the relatively expensive $XeF_2$ crystals used.

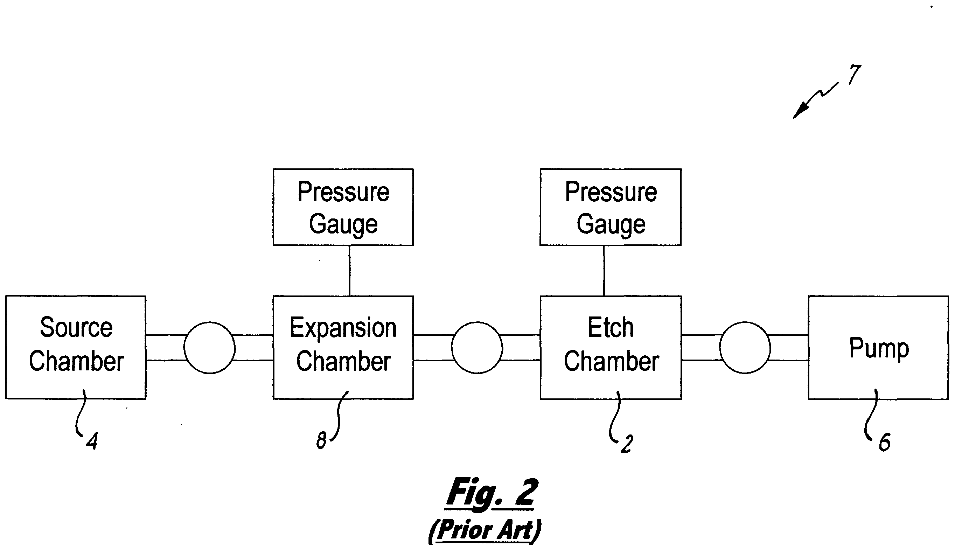

In order to attempt to circumvent one or more of the above disadvantages, so-called pulsed etching apparatus have been developed. The first of these was described in P. B. Chu, J. T. Chen, R. Yeh, G. Lin, J. C. P Huang, B. A. Warneke, and K. S. J. Pister, "Controlled Pulse-Etching with Xenon Difluoride", Transducers '97, Chicago IL., USA, p. 665-668, June 1997. This pulsed etching system 7 is presented schematically in Figure 2. The system can be seen to employ an intermediate chamber, referred to as an expansion chamber 8, to pre-measure a quantity of $XeF_2$ gas and to mix this gas with other gases, such as a nitrogen coolant gas employed to enhance the etching process. The contents in the expansion chamber 8 are then discharged into the etching chamber 2 so as to perform the required etching of the silicon. After the $XeF_2$ gas has been sufficiently reacted, the etching chamber 2, and typically the expansion chamber 8 as well, are evacuated through the use of a roughing pump or vacuum pump 6. This process is repeated until the desired degree of etching of the silicon has occurred.

The pulsed etching system 7 described above still exhibits certain inherent disadvantages. In the first instance it still does not truly control the $XeF_2$ gas flow. The pressure in the etching chamber 2 is determined by the charge pressure in the expansion chamber 8, and so by the volume ratio of the etching chamber 2 to the expansion chamber 8. When the expansion chamber 8 is attached to the etching chamber 2 the pressure inevitably drops. The new partial pressure is dependent on the ratio of the volume of the expansion chamber 8 to the volume of the etching chamber 2. For example, if the etching chamber 2 is the same size as the expansion chamber 8 then when they are connected the partial pressure of the $XeF_2$ is halved. As a direct result the etching rate is also halved. Thus, in such systems the etching rate is dependent on the ratio of expansion chamber 8 to etching chamber 2. Therefore, the etching pressure is not controlled directly and in practice is usually only about half the usable pressure as the expansion chamber 8 and the etching chamber 2 are typically of a similar volume.

A second significant drawback of this system resides in the cyclic operating nature of the system. In particular, since the expansion chamber 8 requires time to fill before the etching begins, is open to the etching chamber 2 during the etching process, and is typically evacuated during the evacuation step of the cycle, it forms a rate-limiting step in the etching process. This limitation arises primarily from the time it takes to refill the expansion chamber 8 with $XeF_2$ gas after the evacuation step of the previous cycle. The waiting time can often be a significant period of the etching cycle thus resulting in the total process time, or the time the device spends in the etching chamber 2, being approximately double that of the actual etching time.

A further drawback of this system results from the fact that when the expansion chamber 8 and the etching chamber 2 are connected they are also isolated from any external influence. Thus the partial pressure of the $XeF_2$ vapour in the chambers at the instant they are connected is maximised. However, as the etching proceeds the amount of $XeF_2$ vapour in the chamber drops and as this happens the etching rate also drops. In trying to maximise the utilisation of $XeF_2$ for etching purposes extremely long etching times result. Furthermore, in a practical etching system there will also always be $XeF_2$ vapour pumped away.

An improved pulsed etching system is described in US Patent Application No. US 2002/0033229 in the name of Lebouitz et al. This application teaches of a system that comprises variable volume expansion chambers, fixed volume expansion chambers, or combinations thereof, in fluid communication with an etching chamber and a source of etching gas, such as $XeF_2$ gas. The incorporation of multiple expansion chambers alleviates the down time experienced in refilling the expansion chamber of the Chu et al. system. Furthermore, the fact that the expansion chambers are collapsible allows for some control of the etching pressure, however this pressure control is still only of a secondary nature.

A further alternative pulsed etching system is described in US Patent Application No. US 2002/0195423 in the name Reflectivity Inc. This application teaches of a pulsed etching system that again comprises variable volume expansion chambers. A significant addition to this particular system is the inclusion of a re-circulating pumping system. Thus, once the etching chamber is charged the pump is used to re-circulate the gas in an attempt to improve etching rate and uniformity of the process.

A significant drawback of both the Lebouitz et al. system and the Reflectivity Inc. system is the increased engineering required to produce the device and the increased capital involved with not only the increased engineering but the additional components required.

Japan Patent Application No. JP S61-181131 discloses a simple method of etching silicon wafers in a process chamber, wherein an amount of $XeF_2$ etchant vapour, which is supplied to and removed from said process chamber, controls an amount of anisotropic etching of said silicon wafers in said process chamber.

## Summary of Invention

According to a an aspect of the present invention there is provided a method of etching one or more microstructures located within a process chamber according to claim 1. The method comprises the steps of:

a) transforming an etching material within a sealed chamber from a first state into an etching material vapour;
b) employing a carrier gas to the sealed chamber to transport the etching material vapour from the sealed chamber and thereafter supply the etching material vapour to the process chamber; and
c) controlling the amount of etching material vapour within the process chamber by controlling a vacuum pumping rate from the process chamber;

wherein a rate at which the etching material vapour is supplied to the process chamber is selected in response to a desired etch rate and a rate of removal of the etching material vapour from the process chamber.

Preferred features of this method are set out in the claims 2-24.

**Brief Description of Drawings**

Aspects and advantages of the present invention will become apparent upon reading the following detailed description and upon reference to the following drawings in which:

FIGURE 1   presents a schematic representation of the apparatus employed within the prior art for carrying out a continuous $XeF_2$ etching process;

FIGURE 2   presents a schematic representation of the apparatus employed within the prior art for carrying out a pulsed $XeF_2$ etching process;

FIGURE 3   presents a schematic representation of an apparatus employed for gas phase etching of a micro electromechanical microstructure in accordance with an aspect of the present invention;

FIGURE 4   presents a schematic representation of an etching gas source comprising an etching gas supply system employed within the apparatus of Figure 3;

FIGURE 5   presents a schematic representation of a process chamber employed within the apparatus of Figure 3;

FIGURE 6   illustrates schematically the dependence of the etch rate on the partial pressure of $XeF_2$, and subsequent dependencies on other parts of the gas phase etching apparatus of Figure 3;

FIGURE 7   presents a schematic representation of a breakthrough step employed by the gas phase etching apparatus of Figure 3;

FIGURE 8   presents a schematic representation of an alternative etching gas supply system to that of Figure 4, incorporating artificial mechanical voids within a packed structure;

FIGURE 9   presents a schematic representation of another alternative etching gas supply system to that of Figure 4, incorporating a mechanical vibrator;

FIGURE 10   presents a schematic representation of a further alternative etching gas supply system to that of Figure 4, incorporating a carrier gas mixing system;

FIGURE 11   presents a schematic representation of a yet further alternative etching gas supply system to that of Figure 4, incorporating an entrance conduit support, a thermally conductive mesh, and a thermally conductive packing material;

FIGURE 12   presents a schematic representation of an etching gas source comprising an overflow etching gas supply system;

FIGURE 13   presents a schematic representation of an etching gas source comprising a double etching gas supply system as alternative to the etching gas supply system of Figure 4;

FIGURE 14   presents a schematic representation of a pressurised etching gas source;

FIGURE 15   presents a graph illustrative of the rise of $XeF_2$ pressure within a process chamber when gas flow out of the process chamber is stopped, using the gas phase etching apparatus of Figure 3 comprising the pressurised etching gas source of Figure 14;

FIGURE 16   presents a schematic representation of an etching gas source comprising a mass flow meter to monitor etching gas flow; and

FIGURE 17   presents a schematic representation of an etching gas source comprising an additional gas line adopted for the purpose of carrier gas compensation.

**Detailed Description**

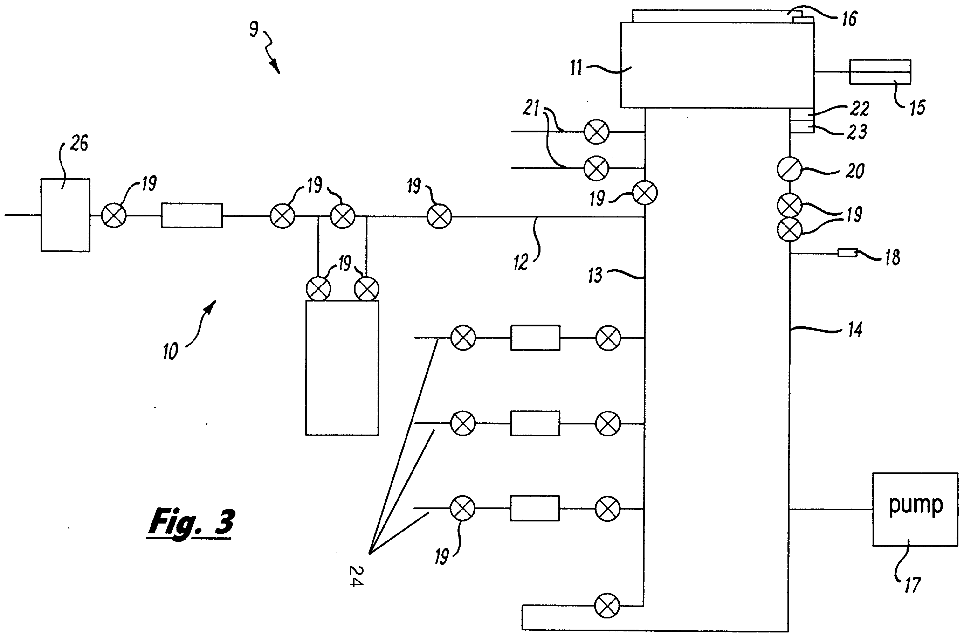

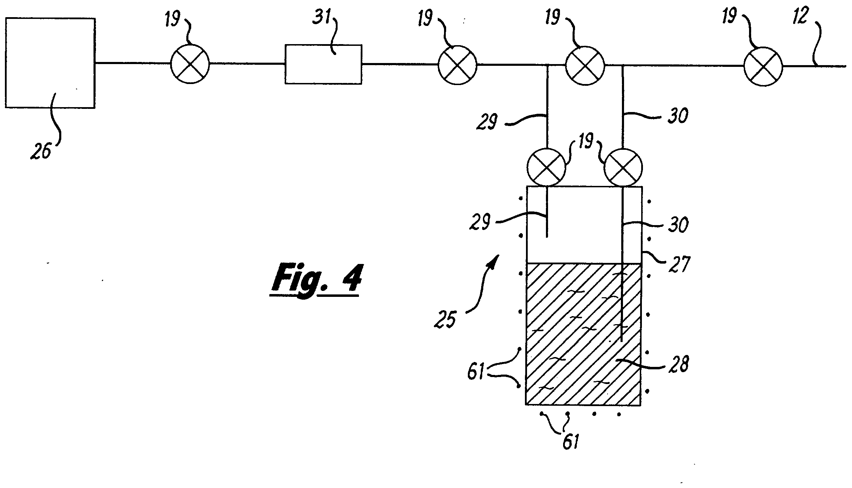

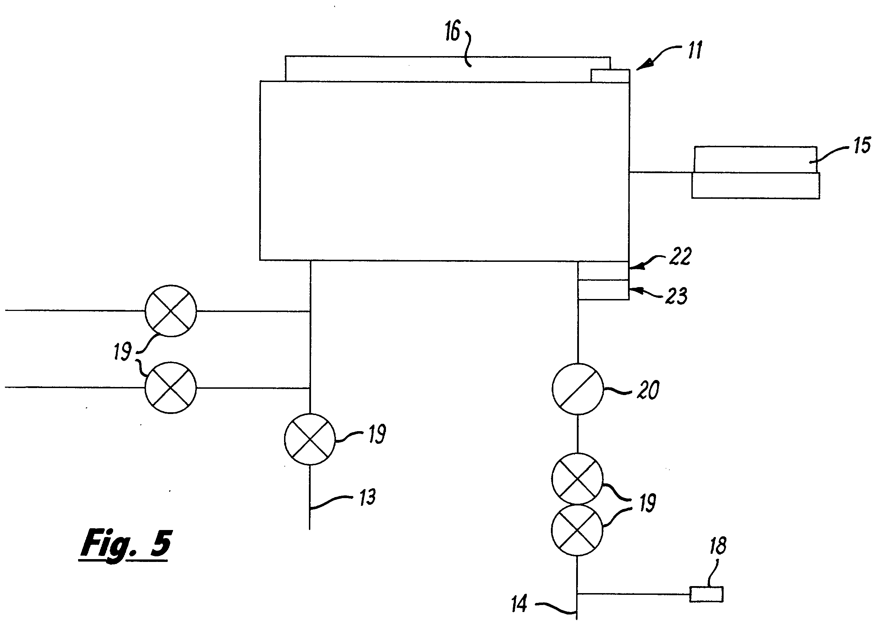

Referring initially to Figure 3 a schematic representation of a gas phase etching apparatus 9, employed for the manufacture of micro electromechanical microstructures (MEMS) in accordance with an aspect of the present invention is presented. The gas phase etching apparatus 9 can be seen to comprise an etching gas source, depicted generally at 10 and shown in further detail within Figure 4, and a process chamber, depicted generally at 11 and shown in further detail within Figure 5.

The etching gas source 10 is employed to provide the required $XeF_2$ etching vapour to the process chamber 11 via a first gas supply line 12 and a process chamber input line 13. Also coupled to the process chamber 11 is a pumping line 14 and a first pressure gauge 15 that provides a means for determining the pressure within the process chamber 11. The process chamber 11 can be seen to further comprise a lid 16 that provides a means of access to the process chamber 11 so as to allow for the loading and unloading of the MEMS devices, as and when required.

Samples, specifically wafers, can be located automatically through a side port when the chamber is connected to an automatic wafer handling system.

Located within the pumping line 14 is a vacuum pump 17, a second pressure gauge 18, two valves 19 and an automatic pressure control switch 20. The combination of these elements provides a means for producing and maintaining a vacuum within the process chamber 11, and then to control a chamber pressure with controlled set gas flows at a sufficient level to allow for the etching process to take place, as is known to those skilled in the art.

From Figure 3 it can be seen that located within the process chamber input line 13 is a vent line 21 that provides a means for venting the process chamber 11. In particular, the vent line 21 is employed to allow for a flow of gas into the process chamber 11 when the vacuum pump 17 isolated from the system so as to raise the process chamber 11 pressure to atmosphere thus allowing the lid 16 to be opened. In this embodiment the gas supplied is nitrogen although air may also be used as an alternative.

An atmospheric switch 22 and an over pressure switch 23 are also located within the pumping line 14. The function of the atmospheric switch 22 is to provide a means for indicating when the process chamber 11 is at atmospheric pressure and so the lid 16 can be opened. The over pressure switch 23 is linked to an apparatus control system (not shown) and provides a safety override for the process chamber 11.

From Figure 3 it can also be seen that located within the process chamber input line 13 are three (can be any number) additional gas supply lines 24 that can be employed to supply further process gases to the process chamber 11, as and when required. The process chamber input line 13 is connected to the pumping line 14 so as to provide a means for pumping out these additional gas supply lines 24.

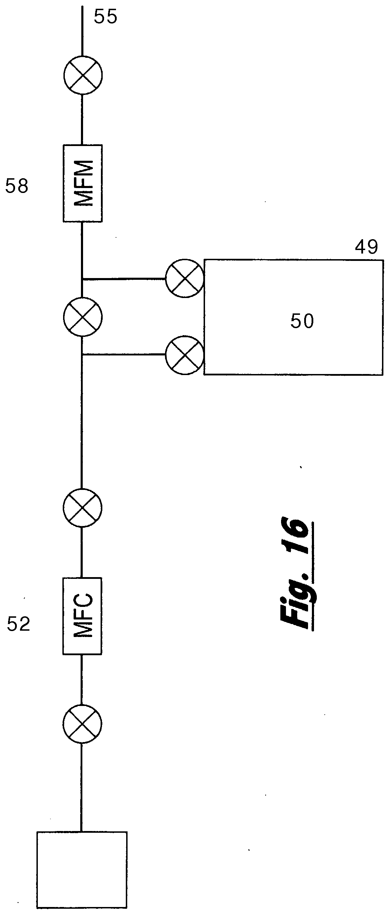

Figure 4 presents further detail of the etching gas source 10. The etching gas source 10 can be seen to comprises an etching gas supply system 25 and a carrier gas source 26 both of which are located within the first gas supply line 12. The etching gas supply system 25 comprises a sealed chamber 27 that houses $XeF_2$ crystals 28, an entrance conduit 29 and an exit conduit 30. The entrance conduit 29 is located above the surface of the $XeF_2$ crystals 28 and functions to provide a means for delivering a carrier gas, namely helium gas (He), from the carrier gas source 26 directly to the $XeF_2$ crystals 28. The exit conduit 30 penetrates below the level of the $XeF_2$ crystals 28 and is employed as a means to deliver $XeF_2$ vapour, carried by the helium carrier gas, to the process chamber 11. Temperature control within the sealed chamber 27 is achieved by the incorporation of heating elements 61 located at the external surface of the chamber. In an alternative embodiment the heating elements 61 may extend underneath the sealed chamber 27, and in yet another embodiment the heating elements 61 may provide heat to all of the components of the apparatus. Volume flow control of the carrier gas within the system is regulated by the combination of valves 19 and a Mass Flow Control (MFC) device 31 located within the first gas supply line 12. An MFM on the first gas supply line 12 may monitor the gas flow in the line and by comparison with the carrier gas MFC supply the $XeF_2$ flow can be determined. (See Figure 16 and accompanying discussion below).

The principle of operation of the gas phase etching apparatus 9 is as follows. When the partial pressure of the $XeF_2$ vapour within the sealed chamber 27 is less than ~533 Pa (~4 Torr) then sublimation of the $XeF_2$ crystals 28 occurs and $XeF_2$ vapour is formed within the sealed chamber 27. The helium gas within the carrier gas source 26 is maintained at a pressure of ~207 kPa (~30 psi) such that when an electrical signal is supplied to the MFC device 31 a controlled supply of helium gas to the sealed chamber 27 is achieved. The helium gas then acts to pick up the $XeF_2$ vapour that has sublimated from the $XeF_2$ crystals 28 and carry it, via the exit conduit 30, to the process chamber 11. Etching of one or more MEMS devices located within the process chamber 11 can then take place in a similar fashion to that known to those skilled in the art. It should be noted that the helium carrier gas also provides a secondary function in that it acts as a coolant for the etching process so increasing the efficiency of this process.

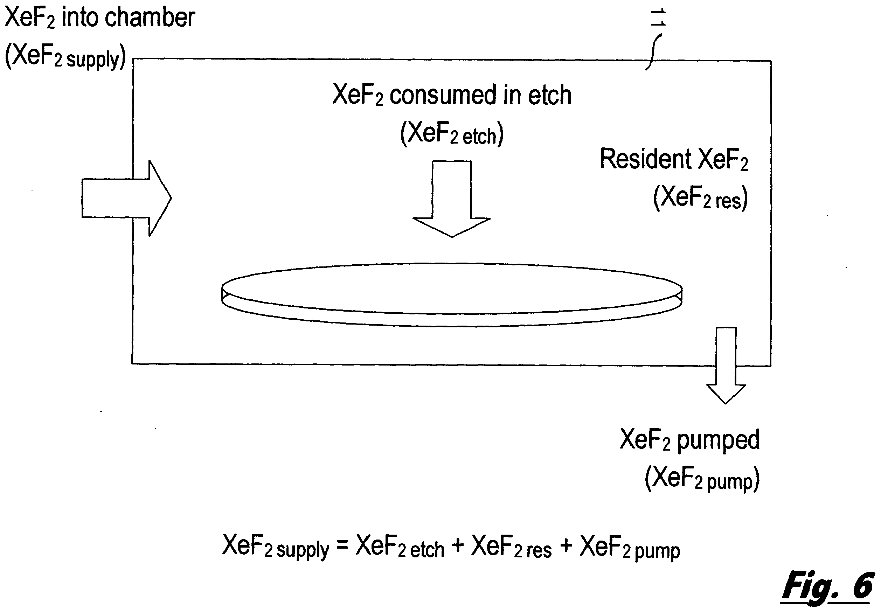

In practice, it is found that the etch rate is dependent on the partial pressure of the $XeF_2$ in the process chamber 11. The $XeF_2$ partial pressure in turn is dependent on the amount of $XeF_2$ being supplied to the process chamber 11, the $XeF_2$ being consumed by the etching process and the amount of $XeF_2$, if any, being pumped away, as presented schematically in Figure 6 and expressed in Equation (2) below:

$$XeF_{2\ supply} = XeF_{2\ etch} + XeF_{2\ pump} + XeF_{2\ res} \quad (2)$$

Thus, the amount of $XeF_2$ supplied to the process chamber 11 ($XeF_{2\ supply}$) is in equilibrium with the amount

of $XeF_2$ being consumed by the etching process ($XeF_{2\,etch}$), the $XeF_2$ being pumped from the process chamber 11 ($XeF_{2\,pump}$) and the amount of $XeF_2$ resident in the process chamber 11 ($XeF_{2\,res}$).

It is the amount of $XeF_2$ resident in the process chamber 11 that ultimately determines the partial pressure of the $XeF_2$. Thus, to achieve as high an etching rate as possible, the partial pressure of $XeF_2$ in the process chamber 11 needs to be as high as possible. However, there is an upper limit in that the partial pressure of $XeF_2$ must not exceed the vapour pressure or else the $XeF_2$ vapour will recrystallise. Typically, the vapour pressure of $XeF_2$ at room temperature is -533 Pa (~4T) and is known to be temperature dependent such that increasing the temperature increases the vapour pressure. Therefore, it is found that by employing heating elements 61 to heat the sealed chamber 27, the first gas supply line 12, the process chamber input line 13 and the process chamber 11 acts to increase the vapour pressure, so allowing a higher $XeF_2$ partial pressure to be obtained.

The partial pressure of $XeF_2$ must not rise above the vapour pressure for the temperature of the system or recrystallisation will occur. In many systems it is common to have the etching gas source at a given temperature and then have the subsequent components up to and including the processing chamber at a higher temperature to ensure no recrystallisation of the $XeF_2$ will occur. This set-up will lead to a more complex apparatus. The amount of components requiring to be heated can be reduced. With very good system control, heating of the process chamber may not be required.

To further illustrate this point consider the complete gas phase etching apparatus 9 as a single system all at the same temperature, e.g. room temperature ~25°C. The vapour pressure of the $XeF_2$ is thus ~533 Pa (~4 Torr). The rate of sublimation of $XeF_2$ is dependent on the temperature, the crystal surface area and the partial pressure of the $XeF_2$. At a set temperature the etching gas source 10 is capable of supplying a set amount of $XeF_2$ vapour into the process chamber 11. The pumping speed is then set to control the amount of $XeF_2$ resident in the process chamber 11. Thus, the remaining mechanism for removing the $XeF_2$ vapour from the process chamber 11 is the etch itself. The amount of $XeF_2$ being consumed in the etch process is primarily dependent on the amount of exposed silicon, e.g. for the same photolithography pattern a 150mm diameter wafer will consume $XeF_2$ at a faster rate than if it were a 100mm diameter wafer. This means that if there is a large amount of exposed silicon removing $XeF_2$ vapour in the etch process the partial pressure of $XeF_2$ in the process chamber 11 will be reduced to a level much lower than the vapour pressure. Therefore, in practice the supply of $XeF_2$ vapour can be increased, as long as the partial pressure of $XeF_2$ remains below the vapour pressure, so increasing the overall etch rate. Thus, by increasing the temperature of the etching gas source 10 the vapour pressure in the etching gas source 10 increases and therefore the $XeF_2$ crystals generate more $XeF_2$ vapour. Supplying more $XeF_2$ vapour to the process chamber 11 increases the partial pressure of $XeF_2$ and leads to higher etch rates.

The above described method relies on very good control of the etch process. As the etch proceeds the system is stable and balanced with the $XeF_2$ supply being matched by the etch rate and the pumping rate. At the end of the etch, whether caused by running out of silicon in a sacrificial mode or ending the etch in a timed mode the etch dynamics change. As the $XeF_2$ being removed due to etching silicon reduces, or is removed completely, the supply of $XeF_2$ to the chamber or the $XeF_2$ vapour removed by pumping must be further controlled to ensure that the partial pressure of $XeF_2$ in the etch chamber does not rise above the vapour pressure. In the case of a sacrificial etch an endpoint/process monitor in a feedback loop is required to determine when the etch dynamics are changing and a system response is required.

It will be appreciated by those skilled in the art that the etch rate may be further increased, in a similar manner, by also increasing the temperature of the process chamber 11, thereby allowing a higher partial pressure of $XeF_2$ to be employed in the process chamber.

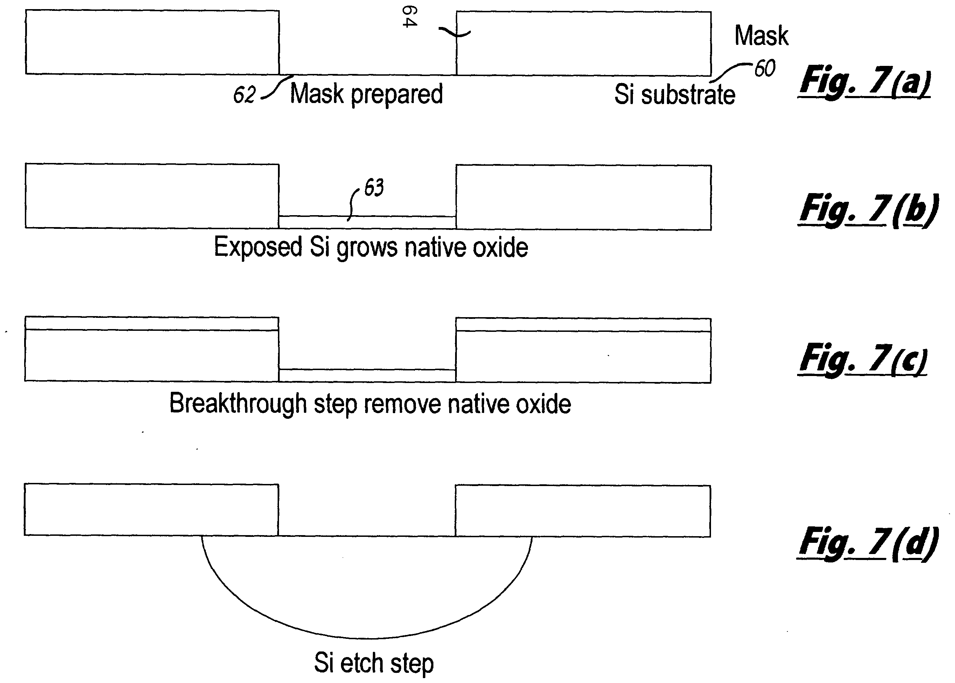

As is known to those skilled in the art there normally exists a number of processing steps carried out on a MEMS structure before etching takes place. These steps are illustrated schematically in Figure 7 and include the preparation of a sample 60 and the manufacture of a mask 64, see Figure 7(a). The exposed silicon 62 to be etched, if left in a suitable environment, will grow a thin oxide layer 63, referred to as native oxide, see Figure 7(b). The thickness of this layer is dependent on the time left exposed.

In highly selective silicon etch processes, e.g. $XeF_2$ etching, the time taken to etch the native oxide can be considerable. Also, as the thickness of this layer is dependent on the time the silicon has been exposed the thickness of the native oxide can be variable. To remove the native oxide within the gas phase etching apparatus 9 a separate processing breakthrough step can be introduced. This step is used only to remove the native oxide and since it is optimised for this purpose leads to faster and more controlled processing of the MEMS.

The breakthrough step can be achieved by using a $SiO_2$ etch process, commonly a plasma etch using fluorine chemistry. However, it is possible to use the $XeF_2$ vapour as the source of the fluorine etch. The $XeF_2$ can be disassociated by the application of energy from various sources, e.g. plasma, ion bombardment but preferably UV light. The disassociated fluorine will then etch the oxide layer.

Alternatively, the breakthrough step is achieved, when using $XeF_2$ as the silicon etching gas, by initially adding a small controlled amount of water vapour to the process chamber 11 during the breakthrough step. Since $XeF_2$ reacts with the water vapour to produce hydrofluoric acid (HF), the resultant HF etches the native oxide. When an oxide is employed as the mask 64 this will also be etched by the HF. However, the duration of the breakthrough step is relatively short and so only a small amount of mask material will normally be consumed, see Figure 7(c). With the breakthrough step complete the water vapour and any residual HF vapour is removed and the silicon etch process step begins as represented in Figure 7(d). Employing the breakthrough step leads to better process control and a more repeatable process from sample to sample.

The efficiency of the pick up process of the $XeF_2$ vapour by the helium carrier gas is found to depend on a number of factors including:

- The volume of $XeF_2$ crystals 28 present in the sealed chamber 27;
- The $XeF_2$ vapour pressure, that is known to be temperature dependent;
- The flow rate of the helium carrier gas;
- The pressure within the sealed chamber 27;
- The packing density and crystal size of the $XeF_2$ crystals 28; and
- The geometry of the sealed chamber 27.

An unfavourable process found to take place within the etching gas supply system 25 employed within the present invention is the tendency of the helium carrier gas to create preferential channels through the densely packed $XeF_2$ crystals 28. As the helium gas flows through these channels there is less vapour pick up as there is a smaller area of contact between the carrier gas and the $XeF_2$ crystals 28.

As the channels through the $XeF_2$ crystals 28 continue to expand the efficiency of the pick up of the carrier gas deteriorates until the $XeF_2$ packed structure becomes unstable. The $XeF_2$ packed structure will then collapse upon itself so that the carrier gas pick up process is of a different form. The described channel formation process therefore results in a non uniform pick up and depletion of the $XeF_2$ crystals 28.

Various alternatives of the etching gas supply system shall now be described which are designed to reduce the problematic effect of channel formation through the $XeF_2$ crystals 28.

In a first alternative the position of the lower ends of the entrance conduit 29 and the exit conduit 30 can be varied. For example both lower ends may be located above or below the top surface of the $XeF_2$ crystals 28. Alternatively, only the lower end of the exit conduit 30 or the entrance conduit 29 is located below the top surface of the $XeF_2$ crystals 28.

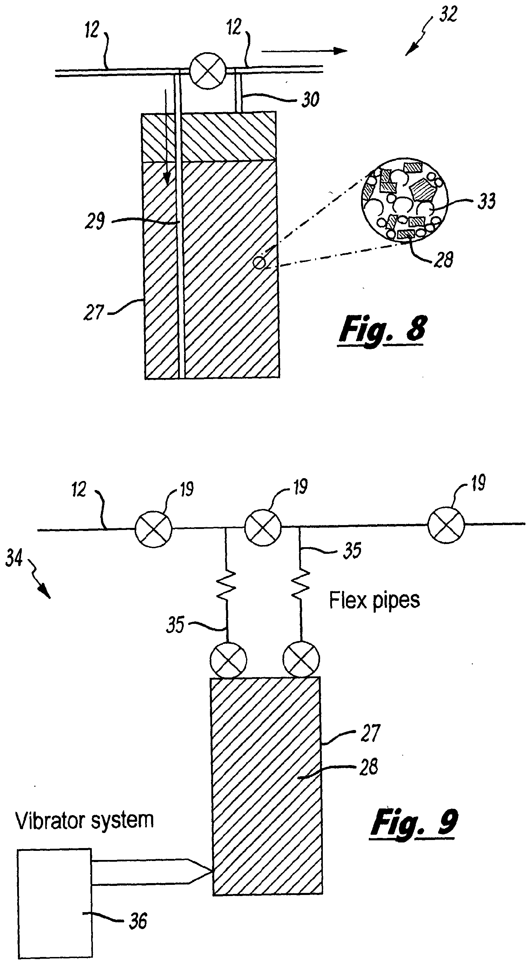

Figure 8 illustrates an alternative etching gas supply system 32 that comprises packing material 33 in the form of small cylinders made from polytetrafluoroethylene (PTFE), that have been added periodically throughout the $XeF_2$ crystals 28. The addition of the packing material 33 acts to increase the number of paths available to the helium carrier gas to propagate through the $XeF_2$ crystals 28 and so increases the area of contact between these elements. This results in a more even consumption of the $XeF_2$ crystals 28 due to a reduction in the channel formation process described above. Therefore, the etching gas supply system 32 exhibits a more uniform flow of the $XeF_2$ vapour to the process chamber 11.

Although the packing material 33 has been described as comprising PTFE, any material that does not react with $XeF_2$, in crystal or vapour form, or the carrier gas may also be employed e.g. glass, or stainless steel or aluminium due to their better thermal conduction properties. Furthermore, the packing material 33 may comprise alternative geometrical shapes such as spring structures or spheres.

A further advantage of the packing material 33 is achieved if this material also exhibits good thermal conductivity properties. This is because during periods when the etching gas source 10 is idle (i.e. between wafer runs) the $XeF_2$ crystals 28 and the vapour obtained therefrom reach an equilibrium with the partial pressure of $XeF_2$ in the etching gas source 10 being equal to the vapour pressure for that particular temperature. Sublimation and recrystallisation continues to take place. When the carrier gas starts to flow again in the gas phase etching apparatus 9 the etching gas source 10 is activated so as to again supply the $XeF_2$ vapour and so more sublimation is required. Energy is needed to generate the vapour and in the process of supplying this energy the $XeF_2$ crystals 28 cool down. This in turn slows the sublimation resulting in lower $XeF_2$ vapour flow and a lower etch rate. As the system continues to operate an effective lower temperature equilibrium state is reached and a stable, but reduced, $XeF_2$ vapour flow is achieved. However the employment of a packing material 33 that is thermally conducting results in heat being easily supplied from the walls of the etching gas source 10 and the heating elements 61, therefore reducing the detrimental cooling effect on the $XeF_2$ crystals 28.

Thus, in a highly controlled system as described above, an appropriate amount of additional heat can be added to compensate for the heat being lost through the sublimation process.

Figure 9 presents an alternative apparatus for overcoming the detrimental effect of channelling through the $XeF_2$ crystals 28. Within this alternative apparatus the etching gas supply system 34 comprises a sealed chamber 27 that is connected to the first gas supply line 12 via two flex pipes 35. Located at the lower end of the sealed chamber 27 is a mechanical vibrator 36 which acts in conjunction with the flex pipes 35 to mechanically vibrate the sealed chamber 27. As a direct result of this vibrational motion, the $XeF_2$ crystals 28 contained within the sealed chamber 27 are continuously moved so as to remove the opportunity for gas carrier channels to form through the $XeF_2$ crystals 28. The

mechanical vibrator 36 thus results in reduced channelling and so provides a smoother pick up, and even consumption, of the $XeF_2$ crystals 28.

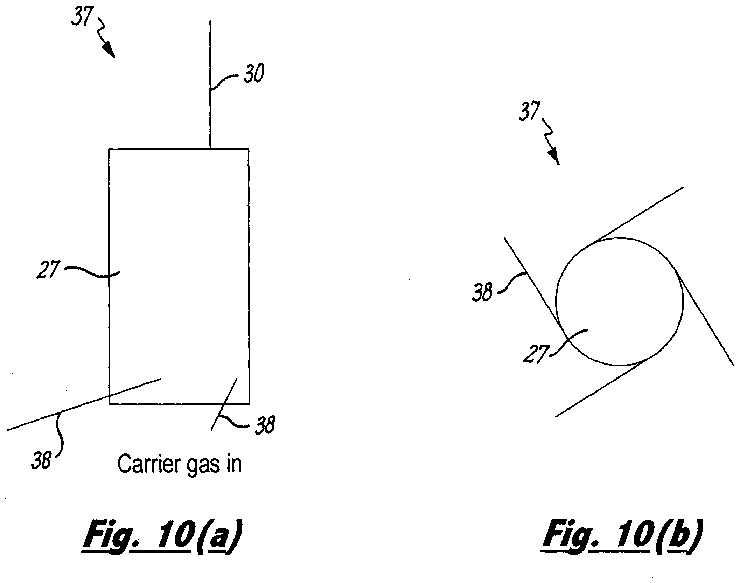

Figures 10(a) and (b) present a schematic front view and plan view of an etching gas supply system 37 in accordance with a further alternative. In this alternative the helium carrier gas is introduced to the lower region of the sealed chamber 27 via four substantially tangential entrance conduits 38. A single exit conduit 30 that is longitudinal is present in order to provide a means for relaying the $XeF_2$ vapour and the helium carrier gas to the process chamber 11, as appropriate.

The introduction of the helium carrier gas via four separate substantially tangential entrance conduits 38 results in a vortex being created within the sealed chamber 27. This vortex acts to stir the $XeF_2$ crystals 28 and so again prevents channels being produced by the carrier gas through the $XeF_2$ crystals 28. Therefore this design of etching gas supply system 37 reduces the opportunity for carrier gas channels to form and so increases the efficiency and uniformity of the supply of $XeF_2$ vapour to the process chamber 11.

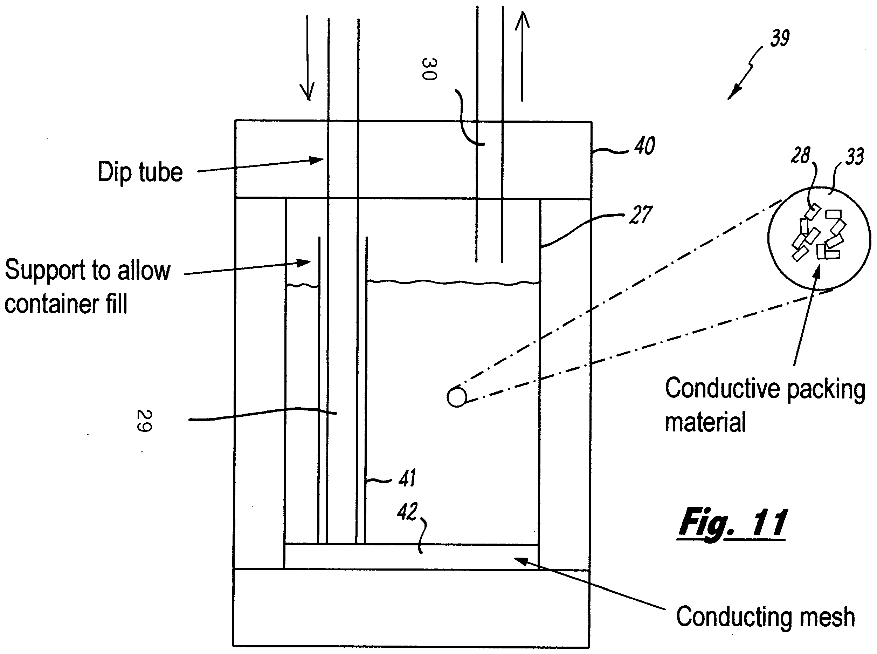

Figure 11 presents a further alternative of the etching gas supply system. As can be seen the etching gas supply system 39 comprises many of the features of the etching gas supply system 32 presented in Figure 8, namely:

1) a sealed chamber 27 that comprises the $XeF_2$ crystals 28 and the packing material 33;
2) an entrance conduit 29 that penetrates down through the $XeF_2$ crystals 28; and
3) an exit conduit 30 that is located above the surface of the $XeF_2$ crystals 28.

In addition to the above features the etching gas supply system 39 further comprises a lid 40 that is removable from the sealed chamber 27 so as to facilitate the filling and removal of material processes. The lid 40 is sealed to the sealed chamber 27 via an O-ring.

Located within the sealed chamber 27 is an entrance conduit support tube 41 that descends to the base of the sealed chamber 27 so as to locate with a thermally conducting mesh support 42. The thermally conducting mesh support 42 is employed so as to allow even access of carrier gas and $XeF_2$ vapour, to the exit conduit 30, via the volume located below the $XeF_2$ crystals 28. This arrangement results in a reduction of the effect of channelling through the $XeF_2$ crystals 28. The presence of entrance conduit support tube 41 means that as the sealed chamber 27 is filled with material a space is always reserved for the entrance conduit 29 to be inserted.

In the presently described alternative the walls of the sealed chamber 27 are made of a transparent material. This allows for the observation of the $XeF_2$ crystals 28 and packing material 33 so allowing useful information to be gathered on the gas dynamics and usage profile within the sealed chamber 27. Furthermore, the employment of transparent walls allows for detectors to be employed so as to automatically detect the material usage within the container.

This can be achieved optically by using a light source, such as an LED or laser, mounted on the side of the sealed chamber 27 with the emitted light impinging on a detector mounted on the opposite side to detect the transmission through the sealed chamber 27. Alternatively the detector could be mounted at some other position where it can detect the reflected beam from the contents of the sealed chamber 27. This arrangement could be used as a level detector to detect the level of $XeF_2$ crystals 28 within the sealed chamber 27.

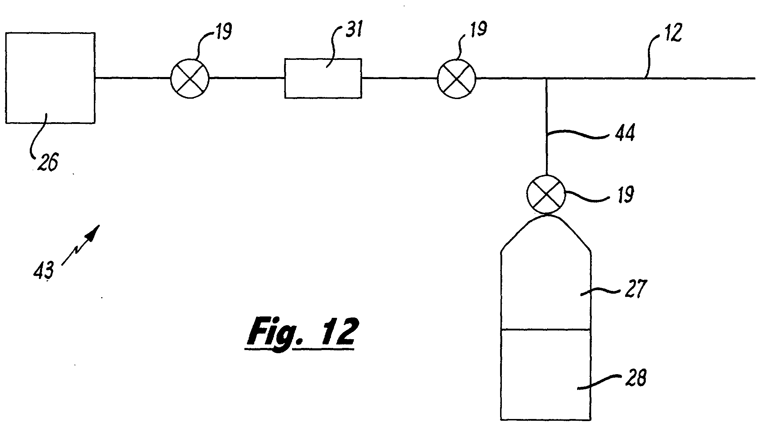

A yet further alternative etching gas supply system 43 falling outside the claimed invention is now described with reference to Figure 12. In this embodiment the sealed chamber 27 is connected to the first gas supply line 12 by a single conduit 44. During operation the pressure within the sealed chamber 27 is maintained at approximately 533 Pa (4 Torr). The helium carrier gas is then caused to flow through the first gas supply line 12 at a pressure of less than 533 Pa (4 Torr). As a result the $XeF_2$ vapour within the sealed chamber 27 is drawn by the carrier gas into the first gas supply line 12 and thereafter transported to the process chamber 11, as required. Continued sublimation of the $XeF_2$ crystals 28 within the sealed chamber 27 acts to maintain the required $XeF_2$ vapour flow so resulting in a continuous and uniform supply of $XeF_2$ vapour to the process chamber 11 as long as the helium gas remains at a pressure below ~533 Pa (~4 Torr).

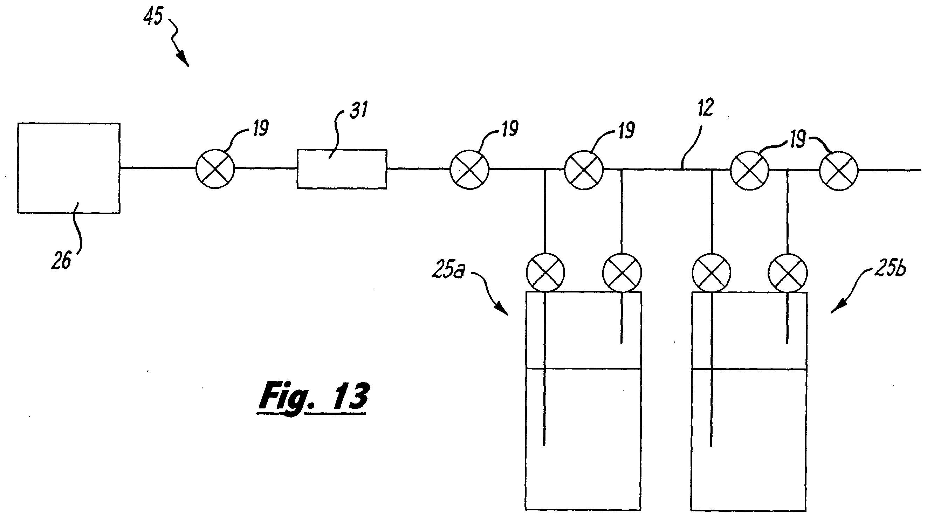

Figure 13 presents a yet further alternative of the etching gas supply system of figure 4, depicted generally at 45 which again provides a more uniform supply of $XeF_2$ vapour to the process chamber 11. In this particular alternative, first and second etching gas supply systems 25a and 25b are located in sequence within the first gas supply line 12. With this set up the helium carrier gas is initially propagated through the first etching gas supply system 25a and then subsequently through the second etching gas supply system 25b so as to ensure that the carrier gas is saturated with $XeF_2$ vapour. The first etching gas supply system 25a is thus preferentially depleted of $XeF_2$ crystals 28 while the second etching gas supply system 25b maintains the level of $XeF_2$ vapour being carried to the process chamber 11 throughout the lifetime of the first etching gas supply system 25a.

When the first etching gas supply system 25a is depleted the valves 19 are closed such that the first etching gas supply system 25a can be removed from the apparatus. The second etching gas supply system 25b is then shifted from its original position to the position of the first etching gas supply system 25a. A new full etching gas supply system is then installed at the original second etching gas supply system's position. The valves 19 are then reopened and production of $XeF_2$ vapour continues as previously described. In practice the volume of $XeF_2$ crystals 28 contained within the etching gas supply system 45 allows the apparatus to operate for several hundred hours before the described replacement method is required to be implemented.

The above described apparatus has been described with reference to $XeF_2$ etching vapour and a helium carrier gas. However it is known that alternative etching vapours and carrier gases may equally well be employed without departing from the scope of the invention. For example the etching material can comprise any noble gas fluoride e.g. krypton difluoride, xenon tetrafluoride and xenon hexafluoride. Alternatively the etching material can comprise a halogen fluoride e.g. bromine trifluoride, chlorine trifluoride or iodine pentafluoride.

Similarly the carrier gas can comprise any of the inert gases. An example of the inert gases that can also be employed is nitrogen gas.

As a further alternative two or more of the above mentioned etching vapours or carrier gases may be employed in combination within the described apparatus.

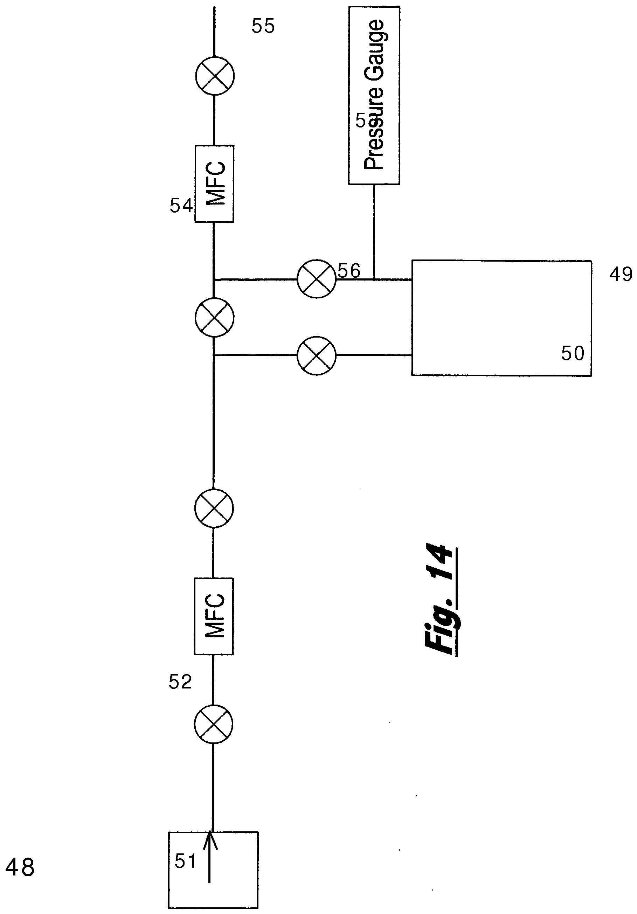

Figure 14 presents a schematic representation of a pressurised etching gas source 48. The pressure in the sealed chamber 49 with only $XeF_2$ crystals 50 present will rise to the vapour pressure at the temperature of the sealed chamber 49 (i.e. ~533 Pa (~4 Torr) at 25°C). When flowing gases it is desirable to control the gas flow with a mass flow controller (MFC), however at low pressure differentials it is difficult to achieve accurate control.

The sealed chamber 49 can be pressurised using another gas, for example an inert gas such as helium. The amount of a pressurising gas 51 being added to the sealed 49 can be controlled by an MFC 52, while monitoring the pressure with a pressure gauge 53. Different amounts of pressurising gas 51 flowing into the sealed chamber 49 results in variations in the $XeF_2$ vapour mixture concentration. With no output flow the partial pressure of the $XeF_2$ will equalise at the vapour pressure.

With an increased sealed chamber pressure a further MFC 54 on the output line 55 can be used to accurately control the amount of gas mixture leaving the sealed chamber 49 and flowing to the process chamber 11.

As the gas mixture leaves the sealed chamber 49 the partial pressure of the $XeF_2$ will drop and sublimation of the $XeF_2$ crystals 50 will increase to re-establish the vapour pressure. By analysing the flow of the pressurising gas 51, the sealed chamber pressure and the flow of the gas mixture leaving the sealed chamber 49, careful process control can be established.

Maintaining a higher pressure in the sealed chamber 49 allows accurate control of the gas flow to the process chamber 11 using the further MFC 54. After stopping the flow of the pressurising gas 51 and opening the output valve 56 of the sealed chamber 49, $XeF_2$ vapour flows to the process chamber 11. The gas can be pumped away from and through the process chamber 11 by the vacuum pump 17. The chamber pressure will be an indication of the amount of $XeF_2$ flowing into the process chamber 11. The amount of $XeF_2$ flow is an indication of the sublimation rate of the $XeF_2$ crystals 50 in the sealed chamber 49. The $XeF_2$ sublimation rate is dependent on various parameters including primarily the amount of $XeF_2$ crystals 50 present in the sealed chamber 49, the temperature of the crystals, the crystal size and packing density, and the geometries of the process chamber 11 and the sealed chamber 49. Determining the $XeF_2$ sublimation rate gives a direct indication of the amount of $XeF_2$ crystals 50 remaining in the sealed chamber 49. This can be used to monitor the $XeF_2$ consumption in the process chamber 11 and indicate when the sealed chamber 49 requires to be replaced or refilled.

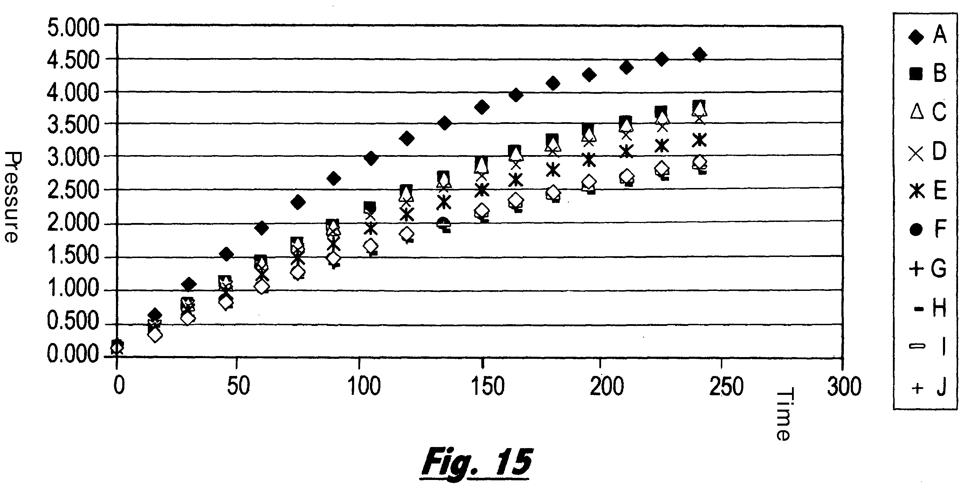

Closing the valve to the vacuum pump 17 stops the gas flowing out of the process chamber 11 and the pressure begins to rise determined by the amount of $XeF_2$ vapour flowing into the process chamber 11. The process chamber pressure rise can be monitored and is normally referred to as a rate of rise. The amount of gas flowing is determined by the sublimation rate of the $XeF_2$ crystals 50 in the sealed chamber 49. The pressure in the process chamber 11 will rise in a distinctive way, as shown in the graph of Figure 15. Initially the rate of rise will be fast and then as the process chamber pressure increases the rate of rise will decrease. The rate of rise will then tend towards zero as the process chamber pressure tends towards the vapour pressure of the $XeF_2$. The speed of the rate of rise and the changes monitored will be directly determined by the $XeF_2$ vapour flow which in turn is determined by the sublimation rate of the $XeF_2$ crystals 50. This can also be used to monitor the $XeF_2$ consumption in the process chamber 11 and indicate when the sealed chamber 49 requires to be replaced or refilled.

Such a technique can be used to monitor the vapour flow as a result of sublimation from any solid or vaporization from any liquid to determine the amount of material remaining in a closed sealed chamber 49.

In the etching gas source shown in Figure 16, a mass flow meter. (MFM) 58 is used to monitor the gas flow output from the sealed chamber 49. The measured flow is a combination of the carrier gas flow and the $XeF_2$ vapour flow. The carrier gas flow is known as it is controlled by the MFC 52 on entry to the sealed chamber 49. Subtracting this flow from the MFM reading and using the appropriate correction factor for the MFM 58 the $XeF_2$ vapour flow can be determined.

To maintain a consistent $XeF_2$ vapour flow, changes can be made automatically by having the MFM reading and the MFC control as part of a feedback loop controlled by system software.

Changes to the $XeF_2$ vapour flow with respect to the carrier gas flow can be used to determine the drop-off in $XeF_2$ and the amount of $XeF_2$ crystals 50 present in the sealed chamber 49. This provides yet another alternative method

of monitoring the $XeF_2$ consumption in the process chamber 11 determine when the sealed chamber 49 is required to be replaced or refilled.

Constantly monitoring the $XeF_2$ gas flow allows the amount of $XeF_2$ leaving the sealed chamber 49 to be determined. This again can be used to monitor the $XeF_2$ usage. Keeping a cumulative record of the usage and comparing with a starting value can therefore also be used to indicate when the sealed chamber 49 is required to be replaced or refilled.

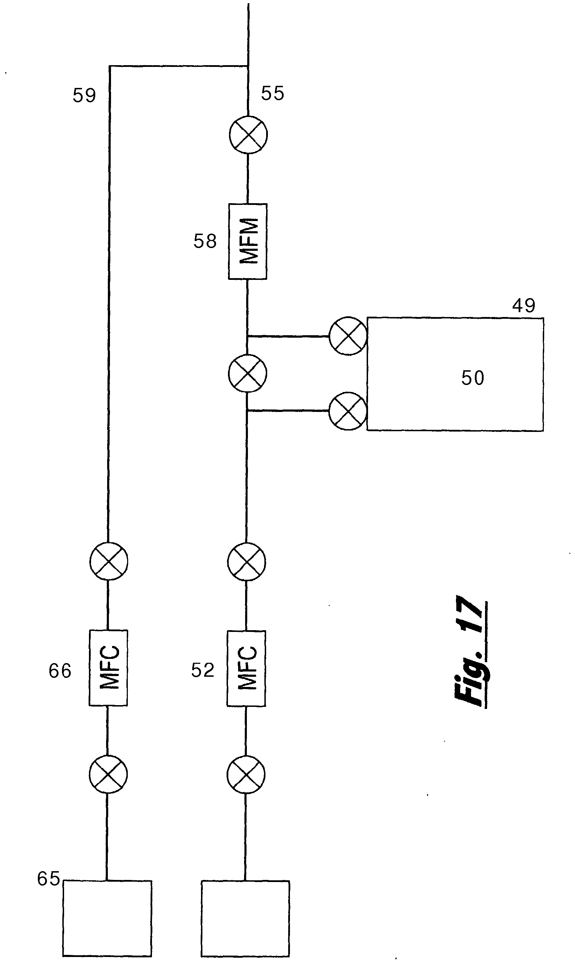

In this single sealed chamber 49 based etching gas source 48, as the $XeF_2$ crystals 50 are consumed to a level where the amount of crystals remaining are insufficient to saturate the carrier gas flow, the amount of $XeF_2$ vapour picked up by the carrier gas drops with respect to the amount of $XeF_2$ crystals 50 remaining in the sealed chamber 49. The MFM 58 on the output line 55 from the sealed chamber 49 will measure the gas flow, and analysis will detect changes in the $XeF_2$ flow and therefore determine changes in $XeF_2$ vapour pick-up. To compensate for the drop-off in $XeF_2$ pick-up, the carrier gas flow can be increased. However this changes the gas flow and hence etching material vapour concentration in the process chamber 11. To maintain a consistent gas flow and $XeF_2$ vapour concentration to the process chamber 11 another gas supply line 59 is used to compensate for the change necessitated in the output line 55. The corresponding etching gas source is shown in Figure 17. As the flow of carrier gas to the sealed chamber 49 is increased to adjust to the drop in $XeF_2$ pick-up the gas supply 65 in the another gas supply line 59 is reduced by the same amount using an additional MFC 66 so that the gas supply to the process chamber 11 is maintained with respect to gas flow and mixture concentration.

The initial gas flow in the another gas supply line 59 needs to be high enough to allow for the increase in the carrier gas flow to compensate for the reduced $XeF_2$ flow. The another gas supply line 59 is preferably flowing the same gas as the carrier gas supply line. The above described apparatus provides a number of significant advantages over those etching gas sources, and related systems, described in the prior art. In the first instance the use of an etching gas supply system allows for a controlled continuous supply of the etching gas to be provided to the process chamber. It is appreciated by those skilled in the art that the cost of $XeF_2$ crystals has reduced significantly in recent years thus making a move towards a continuous flow system significantly more favourable than previously considered. Employment of the described apparatus results in a continuous flow system that maintains the partial pressure of the etching vapour at the maximum partial pressure ($\sim$533 Pa ($\sim$4 Torr) at room temp for $XeF_2$) throughout the etching process. This pressure is maintained as long as there are enough $XeF_2$ crystals to provide the vapour at the flow rate required. Thus, the present invention provides the maximum etching rate achievable and maintains this rate throughout the etching process i.e. there is no drop off in the etching rate as experienced by the prior art systems.

A yet further advantage is that by employing a low pumping rate within the system the residence time of the etching vapour within the process chamber can be maximised. In practice, the pumping rate is set so as to optimise the residence time of the $XeF_2$ vapour within the process chamber and to remove the etching by-products thus maximising the etching rate with a minimal consumption of $XeF_2$ crystals.

A further advantage of the described apparatus is that it does not require the incorporation of any expansion chambers or other complicated mechanical features in order to achieve the continuous flow of etching gas. Therefore, the presently described apparatus is of a significantly simpler design and so is more cost effective to produce and operate than those systems described within the prior art.

The foregoing description of the invention has been presented for purposes of illustration and description and is not intended to be exhaustive or to limit the invention to the precise form disclosed. The described embodiments were chosen and described in order to best explain the principles of the invention and its practical application to thereby enable others skilled in the art to best utilise the invention in various embodiments and with various modifications as are suited to the particular use of the invention contemplated.

Therefore, further modifications or improvements to the described embodiments of the invention may be incorporated without departing from the scope of the invention which is defined by the appended claims.

**Claims**

1. A method of etching one or more microstructures located within a process chamber (11), the method comprising the steps of:

    a) transforming an etching material within a sealed chamber (27; 49) from a first state into an etching material vapour;
    b) employing a carrier gas to the sealed chamber (27; 49) to transport the etching material vapour from the sealed chamber (27; 49) and thereafter supply the etching material vapour to the process chamber (11); and
    c) controlling the amount of etching material vapour within the process chamber (11) by controlling a vacuum pumping rate from the process chamber (11),

**characterised in that** a rate at which the etching material vapour is supplied to the process chamber (11) is selected in response to a desired etch rate and a rate of removal of the etching material vapour from the process chamber (11).

2. The method as described in claim 1 wherein the etching material comprises $XeF_2$.

3. The method as described in claim 1 or claim 2 wherein the method comprises the additional step of employing an additional input process gas to the process chamber (11), and wherein the step of controlling the amount of etching material vapour within the process chamber (11) further comprises the step of selecting a supply rate of the carrier gas to the process chamber (11) and selecting a supply rate of the additional input process gas to the process chamber (11).

4. The method as described in claim 3 wherein the step of selecting the supply rate of the carrier gas to the process chamber (11) and selecting the supply rate of the additional input process gas to the process chamber (11) comprises the step of selectively increasing the supply rate of the carrier gas to the process chamber (11) while selectively reducing the supply rate of the additional input process gas to the process chamber (11) so that the supply of carrier gas, etching material vapour, and additional input process gas to the process chamber (11) is maintained with respect to gas flow and mixture concentration.

5. The method as described in claim 1 or claim 2 wherein the steps (a) and (b) are repeated to ensure that the carrier gas to the process chamber (11) is saturated with the etching material vapour.

6. The method as described in any one of the preceding claims wherein the transformation of the etching material comprises a sublimation of the etching material; the first state is a solid.

7. The method as described in any one of claims 1 to 5 wherein the transformation of the etching material comprises a vaporisation of the etching material; the first state is a liquid.

8. The method as described in any one of the preceding claims wherein the carrier gas to the process chamber (11) also functions as a coolant for the etching of the one or more microstructures within the process chamber (11).

9. The method as described in any one of the preceding claims wherein the carrier gas to the sealed chamber (27; 49) picks up the etching material vapour in the sealed chamber (27; 49) and an efficiency of the pick-up of the etching material vapour by the carrier gas in the sealed chamber (27; 49) is increased by an addition of artificial mechanical voids to the etching material in the sealed chamber (27; 49).

10. The method as described in claim 9 wherein an addition of packing material (33) to the etching material in the sealed chamber (27; 49) creates the artificial mechanical voids in the sealed chamber (27; 49).

11. The method as described in claim 9 or claim 10 wherein the artificial mechanical voids create multiple pathways in the sealed chamber (27; 49) that the carrier gas in the sealed chamber (27; 49) may propagate through such that an area of contact between the carrier gas in the sealed chamber (27; 49) and the etching material in the sealed chamber (27; 49) is increased.

12. The method as described in any one of the preceding claims wherein the carrier gas to the sealed chamber (27; 49) picks up the etching material vapour in the sealed chamber (27; 49) and an efficiency of the pick-up of the etching material vapour by the carrier gas in the sealed chamber (27; 49) is increased by agitating the etching material in the sealed chamber (27; 49).

13. The method as described in any one of the preceding claims wherein an efficiency of the method of etching is increased by heating the etching material in the sealed chamber (27; 49) so as to maintain the etching material in the sealed chamber (27; 49) at a constant predetermined temperature.

14. The method as described in any one of the preceding claims wherein a partial pressure of the etching material vapour within the process chamber (11) is maintained below a vapour pressure of the etching material.

15. The method as described in claim 14 wherein the partial pressure of the etching material vapour within the process chamber (11) is increased by increasing a temperature of the etching material in the sealed chamber (27; 49).

16. The method as described in claim 14 or claim 15 wherein a rate at which the etching occurs is increased by increasing the partial pressure of the etching material vapour within the process chamber (11).

17. The method as described in any one of the preceding claims wherein the method comprises the additional step of selecting a partial pressure of the etching material vapour within the process chamber (11) in response to a size of the one or more microstructures to be etched.

18. The method as described in claim 1 wherein the method comprises the additional step of providing a breakthrough step in which a native oxide layer is etched.

19. The method as described in claim 18 wherein the breakthrough step comprises adding a fluid selected to react with the etching material vapour within the process chamber (11), the product of which etches the native oxide layer.

20. The method as described in claim 19 wherein the breakthrough step further comprises decomposing the etching material vapour within the process chamber (11) using an energy source such as a plasma, an ion beam or UV light.

21. The method as described in any one of the preceding claims wherein the method comprises the additional steps of:

   1). preventing a supply of the carrier gas to the sealed chamber (27; 49);
   2). employing a vacuum pump (17) to pump the etching material vapour from the sealed chamber (27; 49) to the process chamber (11); and
   3). measuring a pressure in the process chamber (11);

   wherein the step of measuring the pressure in the process chamber (11) provides a means of determining an amount of etching material in the sealed chamber (27; 49).

22. The method as described in claim 21 wherein the amount of etching material in the sealed chamber (27; 49) is determined by determining a sublimation rate of the etching material in the sealed chamber (27; 49).

23. The method as described in any one of the preceding claims wherein the method comprises the additional steps of:

   i). preventing a gas flow out of the process chamber (11);
   ii). monitoring a rise in pressure in the process chamber (11); and
   iii). determining a rate of rise in pressure in the process chamber (11); wherein the step of determining the rate of rise in pressure in the process chamber (11) provides a means of monitoring the consumption of etching material in the sealed chamber (27; 49).

24. The method as described in claim 23 further comprising the additional steps of:

   iv). measuring a carrier gas flow to the sealed chamber (27; 49);
   v). measuring a total mass flow of etching material vapour and carrier gas leaving the sealed chamber (27; 49); and
   vi). determining an etching material vapour flow leaving the sealed chamber (27; 49) from the total mass flow of etching material vapour and carrier gas leaving the sealed chamber (27; 49) and the carrier gas flow to the sealed chamber (27; 49); wherein the step of determining the etching material vapour flow leaving the sealed chamber (27; 49) provides a means of feedback to control the carrier gas flow to the sealed chamber (27; 49) in order to provide a controlled supply of etching material vapour to the process chamber (11).

**Patentansprüche**

1. Ein Verfahren zum Ätzen einer oder mehrerer Mikrostrukturen, die in einer Prozesskammer (11) angeordnet sind, wobei das Verfahren die folgenden Schritte umfasst:

   a) Umwandelung eines Ätzmaterials innerhalb einer abgedichteten Kammer (27; 49) von einem ersten Zustand in einen Ätzmaterialdampf,
   b) Zuführung eines Trägergases zur abgedichteten Kammer (27; 49), um den Ätzmaterialdampf aus der abgedichteten Kammer (27; 49) zu transportieren und danach den Ätzmaterialdampf der Prozesskammer (11) zuzuführen, und

c) Steuerung der Menge an Ätzmaterialdampf in der Prozesskammer (11) durch Steuerung einer Vakuumpumprate aus der Prozesskammer (11), **dadurch gekennzeichnet, dass** in Reaktion auf eine gewünschte Ätzrate und eine Geschwindigkeit der Entfernung des Ätzmaterialdampfs aus der Prozesskammer (11) eine Rate ausgewählt wird, mit der der Ätzmaterialdampf der Prozesskammer (11) zugeführt wird.

2. Das Verfahren nach Anspruch 1, wobei das Ätzmaterial $XeF_2$ enthält.

3. Das Verfahren nach Anspruch 1 oder Anspruch 2, wobei das Verfahren den zusätzlichen Schritt der Anwendung eines zusätzlichen Eingangsprozessgases auf die Prozesskammer (11) umfasst und wobei der Schritt der Steuerung der Menge an Ätzmaterialdampf innerhalb der Prozesskammer (11) ferner den Schritt der Auswahl einer Zufuhrrate des Trägergases zur Prozesskammer (11) und der Auswahl einer Zufuhrrate des zusätzlichen Eingangsprozessgases zur Prozesskammer (11) umfasst.

4. Das Verfahren nach Anspruch 3, wobei der Schritt der Auswahl der Zufuhrrate des Trägergases zur Prozesskammer (11) und der Auswahl der Zufuhrrate des zusätzlichen Eingangsprozessgases zur Prozesskammer (11) den Schritt des selektiven Erhöhung der Zufuhrrate des Trägergases zur Prozesskammer (11) umfasst, während selektiv die Zufuhrrate des zusätzlichen Eingangsprozessgases zur Prozesskammer (11) reduziert wird, sodass die Zufuhr von Trägergas, Ätzmaterialdampf und zusätzlich zugeführtem Prozessgas zur Prozesskammer (11) in Bezug auf Gasfluss und Gemischkonzentration konstant gehalten wird.

5. Das Verfahren nach Anspruch 1 oder Anspruch 2, wobei die Schritte (a) und (b) wiederholt werden, um sicherzustellen, dass das zur Prozesskammer (11) strömende Trägergas mit dem Ätzmaterialdampf gesättigt ist.

6. Das Verfahren nach einem der vorhergehenden Ansprüche, wobei die Umwandlung des Ätzmaterials eine Sublimation des Ätzmaterials umfasst; der erste Aggregatzustand ist fest.

7. Das Verfahren nach einem der Ansprüche 1 bis 5, wobei die Umwandlung des Ätzmaterials eine Verdampfung des Ätzmaterials umfasst; der erste Aggregatzustand ist fest.

8. Das Verfahren nach einem der vorherigen Ansprüche, wobei das Trägergas für die Prozesskammer (11) auch als Kühlmittel für das Ätzen der einen oder mehreren Mikrostrukturen innerhalb der Prozesskammer (11) fungiert.

9. Das Verfahren nach einem der vorherigen Ansprüche, wobei das der abgedichteten Kammer (27; 49) zugeführte Trägergas den Ätzmaterialdampf in der abgedichteten Kammer (27; 49) aufnimmt und eine Effizienz der Aufnahme des Ätzmaterialdampfs durch das Trägergas in der abgedichteten Kammer (27; 49) durch die Hinzufügung von künstlichen mechanischen Hohlräumen zum Ätzmaterial in der abgedichteten Kammer (27; 49) erhöht wird.

10. Das Verfahren nach Anspruch 9, wobei ein Zusatz von Packmaterial (33) zum Ätzmaterial in der abgedichteten Kammer (27; 49) die künstlichen mechanischen Hohlräume in der abgedichteten Kammer (27; 49) erzeugt.

11. Das Verfahren nach Anspruch 9 oder Anspruch 10, wobei die künstlichen mechanischen Hohlräume mehrere Wege in der abgedichteten Kammer (27; 49) erzeugen, durch die sich das Trägergas in der abgedichteten Kammer (27; 49) derart ausbreiten kann, dass eine Kontaktfläche zwischen dem Trägergas in der abgedichteten Kammer (27; 49) und dem Ätzmaterial in der abgedichteten Kammer (27; 49) ausgeweitet wird.

12. Das Verfahren nach einem der vorherigen Ansprüche, wobei das der abgedichteten Kammer (27; 49) zugeführte Trägergas den Ätzmaterialdampf in der abgedichteten Kammer (27; 49) aufnimmt und eine Effizienz der Aufnahme des Ätzmaterialdampfs durch das Trägergas in der abgedichteten Kammer (27; 49) durch die Aufwühlung des Ätzmaterials in der abgedichteten Kammer (27; 49) erhöht wird.

13. Das Verfahren nach einem der vorhergehenden Ansprüche, wobei eine Effizienz des Ätzverfahrens erhöht wird, indem das Ätzmaterial in der abgedichteten Kammer (27; 49) erhitzt wird, sodass das Ätzmaterial in der abgedichteten Kammer (27; 49;) auf einer konstanten vorbestimmten Temperatur gehalten wird.

14. Das Verfahren nach einem der vorhergehenden Ansprüche, wobei ein Partialdruck des Ätzmaterialdampfs innerhalb der Prozesskammer (11) unter einem Dampfdruck des Ätzmaterials gehalten wird.

**15.** Das Verfahren nach Anspruch 14, wobei der Partialdruck des Ätzmaterialdampfs in der Prozesskammer (11) durch die Erhöhung einer Temperatur des Ätzmaterials in der abgedichteten Kammer (27; 49) erhöht wird.

**16.** Das Verfahren nach Anspruch 14 oder Anspruch 15, wobei eine Rate, mit der das Ätzen erfolgt, durch die Erhöhung des Partialdrucks des Ätzmaterialdampfs in der Prozesskammer (11) erhöht wird.

**17.** Das Verfahren nach einem der vorhergehenden Ansprüche, wobei das Verfahren den zusätzlichen Schritt der Auswahl eines Partialdrucks des Ätzmaterialdampfs innerhalb der Prozesskammer (11) als Reaktion auf eine Größe der einen oder der mehreren zu ätzenden Mikrostrukturen umfasst.

**18.** Das Verfahren nach Anspruch 1, wobei das Verfahren zudem den Schritt der Bereitstellung eines Durchbruchschritts umfasst, in dem eine natürliche Oxidschicht geätzt wird.

**19.** Das Verfahren nach Anspruch 18, wobei der Durchbruchschritt die Hinzufügung eines Fluids umfasst, das so ausgewählt ist, dass es mit dem Ätzmaterialdampf innerhalb der Prozesskammer (11) reagiert, wobei das Reaktionsprodukt die natürliche Oxidschicht ätzt.

**20.** Das Verfahren nach Anspruch 19, wobei der Durchbruchschritt ferner die Zersetzung des Ätzmaterialdampfs in der Prozesskammer (11) unter Verwendung einer Energiequelle wie Plasma, eines Ionenstrahls oder UV-Lichts umfasst.

**21.** Das Verfahren nach einem der vorhergehenden Ansprüche, wobei das Verfahren die folgenden zusätzlichen Schritte umfasst:

1) Verhinderung einer Zufuhr des Trägergases zur abgedichteten Kammer (27; 49),
2) Einsatz einer Vakuumpumpe (17), um den Ätzmaterialdampf von der abgedichteten Kammer (27; 49) zur Prozesskammer (11) zu pumpen, und
3) Messung eines Drucks in der Prozesskammer (11),

wobei der Schritt der Messung des Drucks in der Prozesskammer (11) ein Mittel zur Bestimmung einer Menge an Ätzmaterial in der abgedichteten Kammer (27; 49) bereitstellt.

**22.** Das Verfahren nach Anspruch 21, wobei die Menge an Ätzmaterial in der abgedichteten Kammer (27; 49) durch die Bestimmung einer Sublimationsrate des Ätzmaterials in der abgedichteten Kammer (27; 49) bestimmt wird.

**23.** Das Verfahren nach einem der vorhergehenden Ansprüche, wobei das Verfahren die folgenden zusätzlichen Schritte umfasst:

i) Verhinderung eines Gasflusses aus der Prozesskammer (11),
ii) Überwachung eines Druckanstiegs in der Prozesskammer (11) und
iii) Bestimmung der Rate eines Druckanstiegs in der Prozesskammer (11),

wobei der Schritt der Bestimmung der Rate des Druckanstiegs in der Prozesskammer (11) ein Mittel zum Überwachung des Verbrauchs von Ätzmaterial in der abgedichteten Kammer (27; 49) bereitstellt.

**24.** Das Verfahren wie in Anspruch 23 beschrieben, das zudem die folgenden Schritte umfasst:

iv) Messung eines Trägergasflusses zur abgedichteten Kammer (27; 49),
v) Messung eines Gesamtmassenflusses von Ätzmaterialdampf und Trägergas, der die abgedichtete Kammer (27; 49) verlässt, und
vi) Bestimmung eines Ätzmaterialdampfflusses, der die abgedichtete Kammer (27; 49) verlässt, aus dem Gesamtmassenfluss von Ätzmaterialdampf und Trägergas, der die abgedichtete Kammer (27; 49) verlässt, und des Trägergasflusses zur abgedichteten Kammer (27; 49), wobei der Schritt der Bestimmung des Ätzmaterialdampfflusses, der die abgedichtete Kammer (27; 49) verlässt, eine Rückkopplungseinrichtung bereitstellt, um den Trägergasfluss zur abgedichteten Kammer (27; 49) zu steuern, um eine gesteuerte Zufuhr von Ätzmaterialdampf zur Prozesskammer (11) bereitzustellen.

**Revendications**

1. Une méthode pour graver une ou plusieurs microstructures se trouvant dans une chambre de traitement (11), la méthode comprenant les étapes suivantes :

   a) transformer un produit d'attaque dans une chambre étanche (27 ; 49) en le vaporisant ;
   b) introduire un gaz porteur dans la chambre étanche (27 ; 49) pour évacuer la vapeur du produit d'attaque de la chambre étanche (27 ; 49) et ensuite pour introduire la vapeur du produit d'attaque dans la chambre de traitement (11) ; et
   c) réguler le volume de vapeur du produit d'attaque dans la chambre de traitement (11) en régulant le débit de la pompe à vide d'extraction de la chambre de traitement (11), le débit de vapeur du produit d'attaque alimentant la chambre de traitement (11) étant sélectionné en fonction du débit souhaité de vapeur d'attaque et du débit d'extraction de la vapeur du produit d'attaque présente dans la chambre de traitement (11).

2. La méthode décrite dans la revendication 1, dans laquelle le produit d'attaque comprend du $XeF_2$.

3. La méthode décrite dans la revendication 1 ou dans la revendication 2, consistant en outre à utiliser du gaz de traitement supplémentaire dans la chambre de traitement (11), et dans laquelle la régulation de la quantité de vapeur de produit d'attaque dans la chambre de traitement (11) consiste en outre à sélectionner un débit d'alimentation en gaz porteur de la chambre de traitement (11) et à sélectionner un débit de gaz de traitement supplémentaire alimentant la chambre de traitement (11).

4. La méthode comme décrite dans la revendication 3, dans laquelle la sélection du débit d'alimentation en gaz porteur de la chambre de traitement (11) et la sélection du débit d'alimentation de gaz de traitement supplémentaires dans la chambre de traitement (11) consiste également à augmenter de manière sélective le débit d'alimentation en gaz porteur de la chambre de traitement (11) tout en diminuant de manière sélective le débit d'alimentation de gaz de traitement supplémentaire dans la chambre de traitement (11) afin que l'alimentation en gaz porteur, en vapeur de produit d'attaque, et en gaz de traitement supplémentaire de la chambre de traitement (11) soit maintenue par rapport au débit de gaz et à la concentration du mélange.

5. La méthode décrite dans la revendication 1 ou dans la revendication 2, dans laquelle les étapes (a) et (b) sont répétées pour s'assurer que le gaz porteur alimentant la chambre de traitement (11) est saturé avec la vapeur du produit d'attaque.

6. La méthode décrite dans l'une des revendications précédentes, dans laquelle la transformation du produit d'attaque consiste à sublimer le produit d'attaque ; le premier état est solide.

7. La méthode décrite dans l'une des revendications 1 à 5, dans laquelle la transformation du produit d'attaque consiste à vaporiser ce produit d'attaque ; le premier état étant liquide.

8. La méthode décrite dans l'une des revendications précédentes, dans laquelle le gaz porteur alimentant la chambre de traitement (11) sert également de gaz de refroidissement pour graver une ou plusieurs structures dans la chambre de traitement (11).

9. La méthode décrite dans l'une des revendications précédentes, dans laquelle le gaz porteur alimentant la chambre étanche (27 ; 49) entraine la vapeur du produit d'attaque dans la chambre étanche (27 ; 49), et l'efficacité d'entrainement de la vapeur du produit d'attaque par le gaz porteur dans la chambre étanche (27 ; 49) étant augmentée en ajoutant mécaniquement des bulles vides artificielles au produit d'attaque dans la chambre étanche (27 ; 49).

10. La méthode décrite dans la revendication 9, dans laquelle l'ajout d'un produit de compaction (33) au produit d'attaque dans la chambre étanche (27 ; 49) génère mécaniquement les bulles artificielles dans la chambre étanche (27 ; 49).

11. La méthode décrite dans la revendication 9 ou dans la revendication 10, dans laquelle les bulles artificielles créées mécaniquement génèrent plusieurs circuits dans la chambre étanche (27 ; 49) que le gaz porteur peut emprunter dans la chambre étanche (27 ; 49) pour se propager afin d'augmenter la surface de contact entre le gaz porteur dans la chambre étanche (27 ; 49) et le produit d'attaque dans la chambre étanche (27 ; 49).

12. La méthode décrite dans l'une des revendications précédentes, dans laquelle le gaz porteur alimentant la chambre étanche (27 ; 49) entraine la vapeur de produit d'attaque dans la chambre étanche (27 ; 49), et dans laquelle l'efficacité de l'entrainement de la vapeur du produit d'attaque par le gaz porteur dans la chambre étanche (27 ; 49) est augmentée en agitant le produit d'attaque dans la chambre étanche (27 ; 49).

13. La méthode décrite dans l'une des revendications précédentes, dans laquelle l'efficacité de la méthode d'attaque est augmentée en réchauffant le produit d'attaque dans la chambre étanche (27 ; 49) afin de maintenir le produit d'attaque dans la chambre étanche (27 ; 49) à une température prédéterminée constante.

14. La méthode décrite dans l'une des revendications précédentes, dans laquelle une pression partielle de la vapeur du produit d'attaque dans la chambre de traitement (11) est maintenue à une pression inférieure à la pression de vaporisation du produit d'attaque.

15. La méthode décrite dans la revendication 14, dans laquelle la pression partielle de la vapeur du produit d'attaque dans la chambre de traitement (11) est augmentée en augmentant la température du produit d'attaque dans la chambre étanche (27 ; 49).

16. La méthode décrite dans la revendication 14 ou dans la revendication 15, dans laquelle la vitesse d'attaque (gravure) est augmentée en augmentant la pression partielle de la vapeur du produit d'attaque dans la chambre de traitement (11).

17. La méthode décrite dans l'une des revendications précédentes, dans laquelle la méthode consiste en outre à sélectionner une pression partielle de vapeur de produit d'attaque dans la chambre de traitement (11) en fonction des dimensions de la ou des microstructures à graver.

18. La méthode décrite dans la revendication 1, la méthode consistant en outre à créer une cassure dans la couche d'oxyde natif gravée.

19. La méthode décrite dans la revendication 18, dans laquelle la cassure consiste à ajouter un fluide sélectionné pour réagir avec la vapeur du produit d'attaque dans la chambre de traitement (11), le produit de cette réaction attaquant (gravant) la couche d'oxyde natif.

20. La méthode décrite dans la revendication 19, dans laquelle la cassure consiste en outre à décomposer la vapeur du produit d'attaque dans la chambre de traitement (11) en utilisant une source d'énergie, comme un plasma, un faisceau d'ions ou de la lumière UV.

21. La méthode décrite dans l'une des revendications précédentes, la méthode comprenant en outre les étapes supplémentaires suivantes :

    1) empêcher le gaz porteur d'alimenter la chambre étanche (27 ; 49) ;
    2) utiliser une pompe à vide (17) pour extraire la vapeur du produit d'attaque dans la chambre étanche (27 ; 49) et pour la transférer dans la chambre de traitement (11) ; et
    3) mesurer la pression dans la chambre de traitement (11) ;

dans laquelle la mesure de la pression dans la chambre de traitement (11) permet de déterminer la quantité de produit d'attaque dans la chambre étanche (27 ; 49).

22. La méthode décrite dans la revendication 21, dans laquelle la quantité du produit d'attaque dans la chambre étanche (27 ; 49) est déterminée en déterminant la vitesse de sublimation du produit d'attaque dans la chambre étanche (27 ; 49).

23. La méthode décrite dans l'une des revendications précédentes, la méthode comprenant en outre les étapes supplémentaires suivantes :

    i) empêcher le gaz de sortir de la chambre de traitement (11) ;
    ii) contrôler l'augmentation de pression dans la chambre de traitement (11) ; et
    iii) déterminer la vitesse d'augmentation de la pression dans la chambre de traitement (11) ;

dans laquelle la détermination de la vitesse d'augmentation de pression dans la chambre de traitement (11) permet de contrôler la consommation de produit d'attaque dans la chambre étanche (27 ; 49).

24. La méthode décrite dans la revendication 23 comprenant en outre les étapes suivantes :

iv) mesurer le débit de gaz porteur alimentant la chambre étanche (27 ; 49) ;

v) mesurer le débit massique total de vapeur de produit d'attaque et de gaz porteur sortant de la chambre étanche (27 ; 49) ; et

vi) Déterminer le débit de vapeur de produit d'attaque sortant de la chambre étanche (27 ; 49) dans le débit massique total de vapeur de produit d'attaque et de gaz porteur sortant de la chambre étanche (27 ; 49) ; et déterminer le débit de gaz porteur alimentant la chambre étanche (27 ; 49) ; dans laquelle la détermination du débit de vapeur de produit d'attaque quittant la chambre étanche (27 ; 49) permet de réguler le débit d'alimentation en gaz porteur de la chambre étanche (27 ; 49) afin de réguler le débit de vapeur de produit d'attaque entrant dans la chambre de traitement (11).

Source Chamber

4

3

2

Etch Chamber

N2

5

Pump

6

1

**_Fig. 1_**
_(Prior Art)_

EP 1 766 665 B1

**Fig. 2**
(Prior Art)

**Fig. 3**

Fig. 4

**_Fig. 5_**

XeF$_2$ into chamber
(XeF$_2$ supply)

XeF$_2$ consumed in etch
(XeF$_2$ etch)

Resident XeF$_2$
(XeF$_2$ res)

XeF$_2$ pumped
(XeF$_2$ pump)

$$XeF_{2\ supply} = XeF_{2\ etch} + XeF_{2\ res} + XeF_{2\ pump}$$

*__Fig. 6__*

EP 1 766 665 B1

64

Mask

62 Mask prepared            Si substrate        60        *Fig. 7(a)*

63

Exposed Si grows native oxide                              *Fig. 7(b)*

Breakthrough step remove native oxide                     *Fig. 7(c)*

Si etch step                                              *Fig. 7(d)*

EP 1 766 665 B1

12 12 32

30

29

33

27 28

**_Fig. 8_**

12 19 19 19

35

34 Flex pipes

35

27

28

Vibrator system

36 **_Fig. 9_**

EP 1 766 665 B1

Carrier gas in

**_Fig. 10(a)_**

**_Fig. 10(b)_**

Dip tube

Support to allow
container fill

Conductive packing
material

Conducting mesh

*Fig. 11*

EP 1 766 665 B1

**_Fig. 12_**

Fig. 13

EP 1 766 665 B1

*Fig. 14*

*Fig. 15*

EP 1 766 665 B1

**_Fig. 16_**

52

58

55

50

49

MFC

MFM

EP 1 766 665 B1

32

*Fig. 17*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5726480 A
- US 20020033229 A
- US 20020195423 A
- JP S61181131 B

**Non-patent literature cited in the description**

- **E. HOFFMAN ; B. WARNEKE ; E. KRUGLICK ; J. WEIGOLD ; K.S.J. PISTER.** 3D structures with pie-zoresistive sensors in standard CMOS. *Proceedings of IEEE Micro Electro Mechanical Systems Work-shop (MEMS '95),* 1995, 288-293
- **F.I. CHANG ; R. YEH ; G. LIN ; P.B. CHU ; E. HOFFMAN ; E.J.J. KRUGLICK ; K.S.J. PISTER ; M.H. HECHT.** Gas-Phase Silicon Micromachining With Xenon Difluoride'', in Microelectronic Structures And Microelectromechanical Devices For Optical Processing And Multimedia Applications, Proc. *SPIE,* 1995, vol. 2641, 117-128
- **P. B. CHU ; J. T. CHEN ; R. YEH ; G. LIN ; J. C. P HUANG ; B. A. WARNEKE ; K. S. J. PISTER.** Controlled Pulse-Etching with Xenon Difluoride. *Transducers '97, Chicago IL., USA,* June 1997, 665-668